# EUROPEAN PATENT APPLICATION

(11) **EP 1 677 122 A1**
(43) Date of publication of application: **05.07.2006**
(21) Application number: 06006672.7
(22) Date of filing: 30.10.2002
(51) Int. Cl.: G01R 31/316

(54) **Integrated semiconductor device**

(30) Priority: 17.02.1994 JP 2005994; 27.05.1994 JP 11324994
(62) Divisional of application: 02024148.5
(71) Applicant: FUJI ELECTRIC CO. LTD., Kawasaki 210 (JP)
(72) Inventor: Yoshida, Kazuhiko, Kawasaki-ku Kawasaki 210 (JP); Fujihira, Tatsuhiko, Kawasaki-ku Kawasaki 210 (JP)
(74) Representative: Bridge-Butler, Alan James

(57) **Abstract**

An integrated semiconductor device comprising a control circuit (2) and a MOS semiconductor element (1) having a gate electrode (16), and integrated with the control circuit (2) on a semiconductor substrate, comprising a gate terminal (G) for testing connected with the gate electrode (16), characterised by including a resistor (44) inserted between the control circuit (2) and a connecting point of the gate terminal (G) for testing and the gate electrode (16), and in which the resistor (44) is short-circuited by trimming.

## Description

The present invention relates to semiconductors, and particularly concerns an integrated semiconductor device (hereinafter referred to as an "IC"), in which a MOS semiconductor element for the power output of the IC and a control circuit are integrated on a semiconductor substrate.

Power ICs have been developed recently in which MOS semiconductor elements such as power MOSFETs, insulated gate bipolar transistors (IGBTs) or the like are used for power output.

A screening operation, which seeks to eliminate defective chips by inspecting chips immediately after the wafer process on the chips is completed, is conducted to improve the reliability of the semiconductor devices.

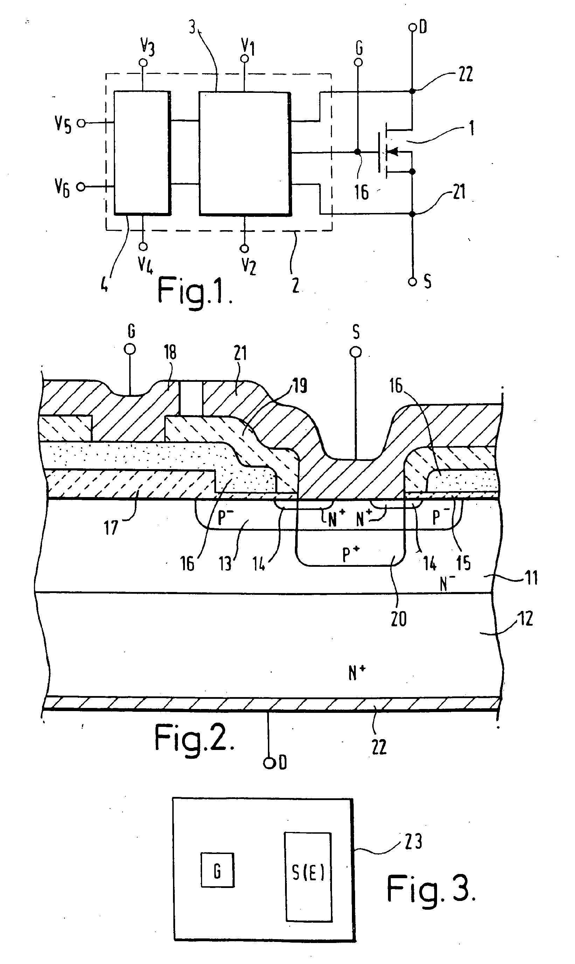

In the accompanying drawings, Figure 2 is a sectional view showing a power MOSFET. A gate screening test is conducted on the individual power MOSFET in its chip stage to detect potentially defective chips, and prevent the progress of such potentially defective chips to successive manufacturing steps. In the chip seen in Figure 2, an N⁻ layer 11 is formed on an N⁺ substrate 12; a P⁻ well 13 is formed in a surface layer of the N⁻ layer 11; and an N⁺ source region 14 is formed in a surface layer of the P⁻ well 13. A polycrystalline silicon gate electrode 16 is formed through a gate oxide film 15 on an area between the source region 14 of the P⁻ well 13 and an exposed portion of the N⁻ layer 11. A gate pad electrode 18 contacts with the gate electrode 16 on a thick field oxide film 17. A source electrode 21, isolated by an interlayer insulation film 19 from the gate electrode 16, contacts in common with a deep P⁺ well 20 formed in a central part of the P⁻ well 13 and the N⁺ source region 14. A drain electrode 22 contacts with the N⁺ substrate 12.

Figure 3 is a diagram showing an upper chip surface of the MOSFET or the IGBT, in which a source or emitter terminal or pad S or E is connected to the source electrode 21 or to an emitter electrode in the case of an IGBT, and a gate terminal or pad G is connected to the gate pad electrode 18, both the source (or emitter) terminal and the gate terminal being disposed on a chip 23.

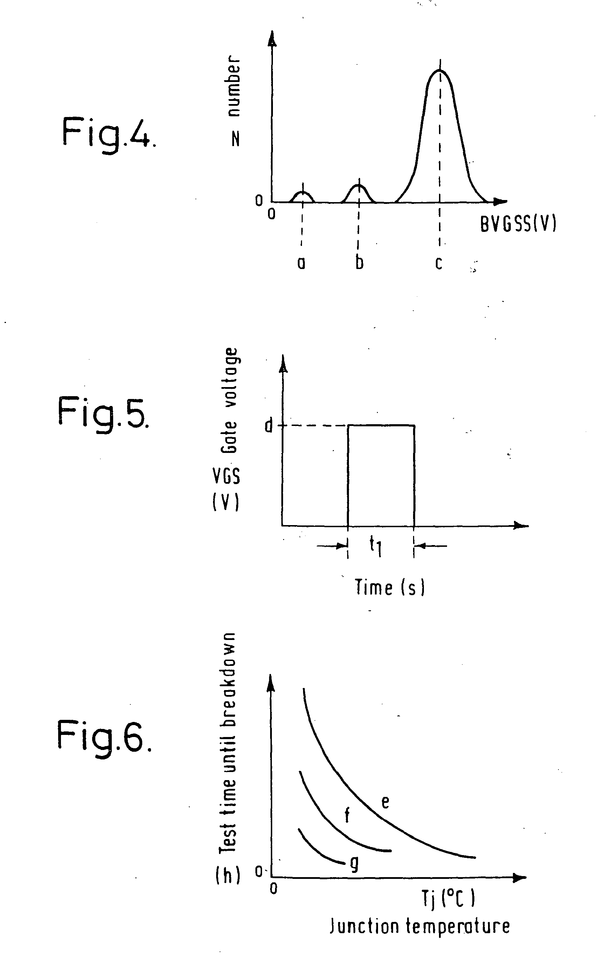

Figure 4 is a chart showing the distribution of the breakdown voltage BV_{GSS} of a sample group of MOSFETs, the breakdown voltage BV_{Gss} being plotted against the number of MOSFETs failing at that voltage when the voltage is applied across the gate terminal G and the source terminal S. As can be seen, small numbers of MOSFETs fail at the lower voltages a and b, while the majority require voltage c to provoke a breakdown. The gate screening test is designed to break defective portions of the P⁻ well 13, gate electrode 16, and the interlayer insulation film 19 as well as the gate oxide film 15 in the elements plotted at or near voltages a and b of Figure 4 by applying, as is shown in Figure 5, a voltage d which is between voltages b and c across the gate electrode G and the source electrode S.

Figure 6 is a chart showing the relationship between the time t necessary to provoke a breakdown of the defective portion and the junction temperature Tj of the chip with the applied voltage d as a parameter. Figure 6 shows that the defective chips which have a defective portion around their gate electrode can be eliminated in a shorter time and at a lower junction temperature as the applied voltage d increases from e to g via f. Clearly, voltages e, f and g are all less than the voltage c at which the majority of elements fail.

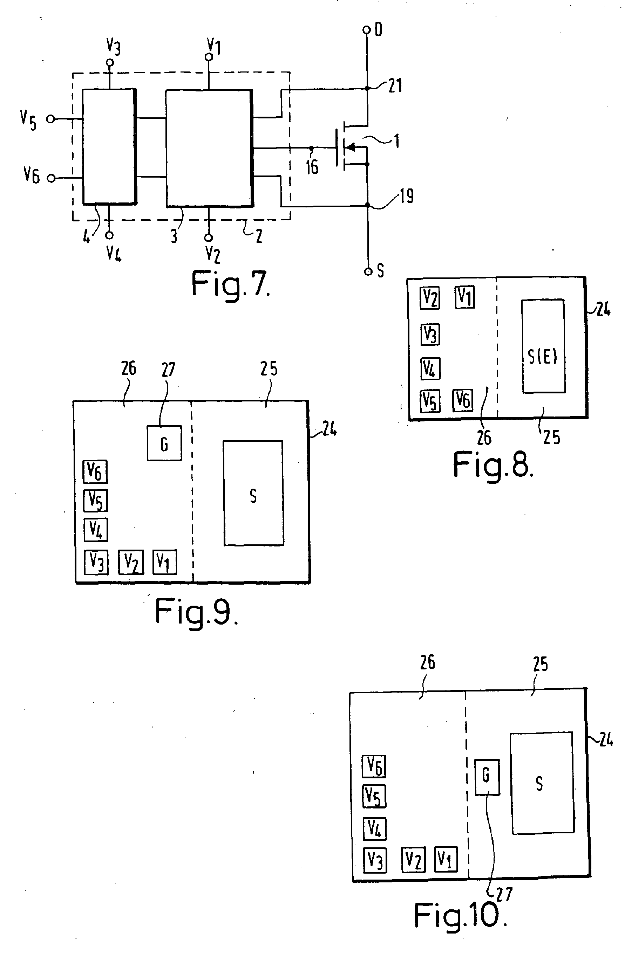

In a conventional power IC, as shown in Figure 7, a control circuit portion 2 comprising a signal processing circuit 3 and a driving/detecting/protecting circuit 4 are connected with the gate electrode 16 of the power MOSFET 1 having the structure shown in Figure 2. The driving/detecting/protecting circuit 4 generally has a withstand voltage lower than that of the power portion. The source terminal S is led out from the source electrode 19 of the power MOSFET 1 shown in Figure 7 and the drain terminal D is led out from its drain electrode 21. Low power terminals V₁ and V₂ are led out from the signal processing circuit 3 and low power terminals V₃, V₄, V₅ and V₆ are led out from the driving/detecting/protecting circuit 4.

Figure 8 shows an upper surface of such a power IC, in which the S terminal of the MOSFET (or the emitter terminal E in the case of an IGBT) is disposed on a power portion 25 of a chip **24,** and the low power terminals V₁, V₂, V₃, V₄, V₅ and V₆ are disposed on a control circuit portion 26 of the chip 24. In the normal operation of the power IC, a voltage as high as voltage d of Figure 5 is not applied to the gate electrode of the MOS power semiconductor element. In most cases, a voltage as low as, for example, the CMOS level or the TTL level is applied to the gate electrode of the MOS power semiconductor element. Therefore, it is necessary to apply the gate voltage at a high temperature and for a long time, as shown by curve e of Figure 6, in order to eliminate defective chips, which have a defect around the gate oxide film of the MOS power semiconductor element such as the MOSFET 1, using the aging test reported by M. Simaya et al. in "The Technical Report of the Institute of Electronics, Information and Communication" (Jpn.) SSD 85-19, pp45-56 (1985) or using the burn-in test reported by K. Furutani et al. in "The Transactions of the Institute of Electronics, Information and Communication" (Jpn.) C-II, Vol. J73-C-II, No. 5, pp302-309 (1990).

EP-A-0 595 355 shows apparatus for screening but in this construction isolated electrodes are formed on a chip and are then connected to each other after screening the chip.

US-A-4 339 710 also shows a screening construction in which a plurality of MOSFETS is switched for testing.

In view of the foregoing, it is an object of the present invention to provide a power IC which facilitates the elimination of defective chips having a defect around the gate oxide film of a high withstand voltage MOS power semiconductor element, by means of a test which can be carried out at low chip temperature in a short time.

According to the present invention, an integrated semiconductor device comprising a control circuit 2 and a MOS semiconductor element 1 having a gate electrode 16, and integrated with the control circuit 2 on a semiconductor substrate, comprising a gate terminal G for testing connected with the gate electrode 16, characterised by including a resistor 44 inserted between the control circuit 2 and a connecting point of the gate terminal G for testing and the gate electrode 16, and in which the resistor 44 is short-circuited by trimming

Since the gate terminal for testing, which is connected to the gate electrode of the MOS semiconductor element for the power output of the power IC, facilitates applying a high gate voltage to the gate electrode of the power output element, defective portions around the gate oxide film are broken down in a time as short as and at a substrate temperature as low as the time and temperature for testing the individual element, and the screening test can thus be conducted with high efficiency. When the applied high voltage is expected to have a detrimental effect on the control circuit, such an effect is avoided by the level shift means, or by the protecting means which is switched to "off" for only the duration of the screening test.

Embodiments of the present invention will now be described in detail with reference to the accompanying drawings, in which :
Figure 1 is a circuit block diagram of an embodiment of the power IC;
Figure 2 is a sectional view showing a power MOSFET used for power out put of the power IC;
Figure 3 is a diagram showing an upper chip surface of an individual MOSFET of the prior art;
Figure 4 is a chart showing th3e distribution of the voltage at which the gate oxide film of the power MOSFET is broken down;
Figure 5 is a wave chart of the applied voltage for the screening test of the power MOSFET;
Figure 6 is a chart showing the relationship between the time necessary for breaking a defective portion and the junction temperature, at various values of applied voltage;
Figure 7 is a circuit block diagram of the power IC according to the prior art;
Figure 8 is a diagram showing an upper chip surface of a power IC of the prior art;
Figure 9 is a diagram showing an upper chip surface of an embodiment of the power IC;
Figure 10 is a diagram showing an upper chip surface of a power IC;
Figure 11 is a circuit block diagram of a third embodiment of the power IC;
Figure 12 is a circuit diagram showing an example of the voltage level shift circuit of the power IC of Figure 11;
Figure 13 is a circuit diagram showing an alternative example of the voltage level shift circuit of the power IC of Figure 11;
Figure 14 is a circuit diagram showing yet a further example of the voltage level shift circuit of the power IC of Figure 11;
Figure 15 is a circuit diagram showing the other example of the voltage level shift circuit of the power IC of Figure 11;
Figure 16 is a circuit block diagram of an embodiment of the power IC according to the present invention; and
Figure 17 is a circuit diagram showing another construction.

Referring now to the drawings, Figure 1 is a circuit block diagram of an embodiment of the IC according to the present invention, in which components corresponding with components of the IC of Figure 7 are designated by the same reference numerals. In this power IC, a gate test terminal G is connected to the gate electrode 16 of the power MOSFET 1. Figures 9 and 10 show upper chip surfaces of the IC, in which the same constituents with those of Figure 8 are designated by the same reference numerals. In Figure 9, a gate (G) terminal 27 is disposed on the control circuit portion 26, while in Figure 10 the gate (G) terminal 27 is disposed on the power portion 25. The gate (G) terminal 27 is used in a gate screening test for applying a high voltage d in the same way as in screening the individual power MOSET shown in Figure 3.

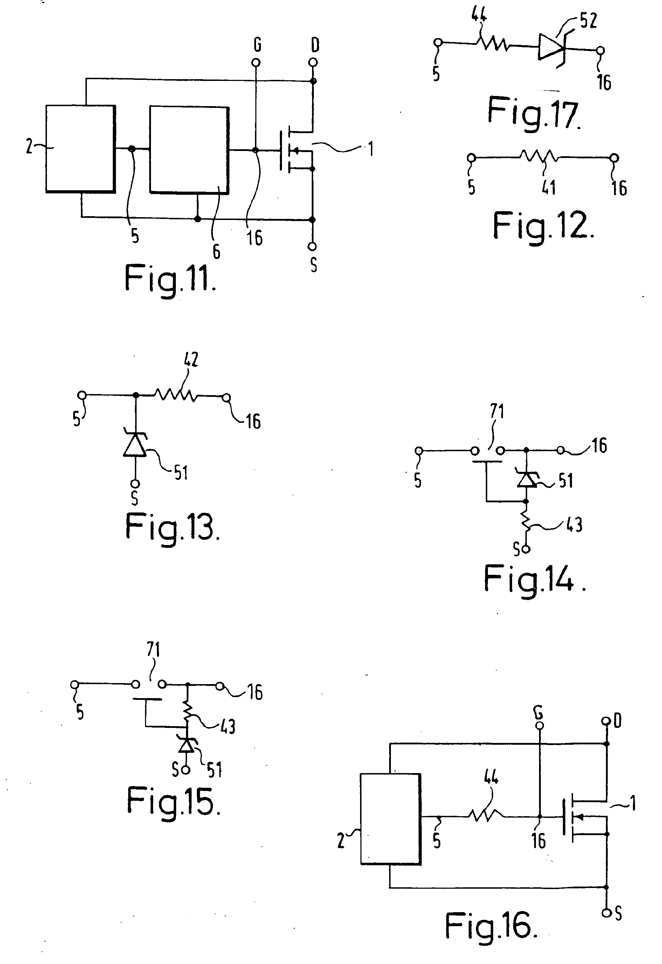

However, when a high voltage is applied during the gate screening test, the control circuit portion 2 connected with the gate electrode may sometimes break down. In the embodiment shown in Figure 11, the high voltage is applied only to the power portion by providing a level shift circuit 6 which shifts (reduces) the level of the gate shock voltage d which is applied to an internal gate terminal 5 of the control portion 2, which may sometimes break down, to a value less than that applied to the gate electrode 16 of the MOSFET 1.

As a level shift circuit 6, a circuit shown in Figure 12 may be used. In this circuit, the screening test voltage applied at the gate electrode 16 is shared between the control circuit 2 and a resistor 41, which may be a diffused resistor formed in a semiconductor substrate or a resistive member deposited on a substrate.

Alternatively, a circuit which keeps the voltage applied to the control circuit 2 at a constant value may be used as the circuit 6, and may be a voltage regulation diode 51 which comprises a PN junction formed by diffusion in a semiconductor substrate or a PN junction of a polycrystalline silicon deposited on a semiconductor substrate. The diode 51 shares the applied voltage with a resistor 42 formed in the same way as the resistor 41.

As a further alternative shown in Figure 14, a circuit comprising a resistor 43 connected to the diode 51 across which a voltage is generated when a voltage exceeding the Zener voltage of the diode 51 is applied and boosts the impedance between the internal gate terminal 5 and the gate electrode 16 high by switching off a normally ON switching element 71 in response to the generated voltage may be used as the circuit 6.

Yet a further alternative is shown in Figure 15, in which the resistor 43 and the diode 51 are connected in the reverse order to that shown in the circuit of Figure 14. Thus, various level shift circuits which lower the voltage at the internal gate terminal of the control circuit may be used in the ICs to ensure that the control circuit survives the gate screening test.

According to the present invention the control circuit portion 2 may be completely separated from the power MOSFET 1 during the gate screening test, and the control circuit portion 2 connected again to the power MOSFET 1 after the test is completed. As shown in Figure 16, a resistor 44 is disposed between the internal gate terminal 5 and the gate electrode 16, a resistor 44 is inserted to limit the voltage during the screening test, and after completion of the test the internal gate terminal 5 and the gate electrode 16 are short-circuited by trimming the resistor 44. The embodiment shown in Figure 17 shows how a diode 52 with high withstand voltage can also be included to also prevent a high voltage from being applied to the internal gate terminal 5 and which can be short-circuited by electrical breakdown.

It is to be understood that the embodiments described above are applicable also to ICs which use an IGBT for their power output.

As has been explained so far, the production efficiency of the power IC is improved by the present invention which facilitates screening the ICs at low substrate temperature in a short time by connecting a gate terminal to the gate electrode of the MOS semiconductor element for power output and by applying to the MOS semiconductor power output element a gate voltage as high as that for testing the individual element.

## Claims

1. An integrated semiconductor device comprising a control circuit (2) and a MOS semiconductor element (1) having a gate electrode (16), and integrated with the control circuit (2) on a semiconductor substrate, comprising a gate terminal (G) for testing connected with the gate electrode (16), **characterised by** including a resistor (44) inserted between the control circuit (2) and a connecting point of the gate terminal (G) for testing and the gate electrode (16), and in which the resistor (44) is short-circuited by trimming.

2. The integrated semiconductor device as claimed in claim 1 which also includes a diode (52) between the resistor (44) and the gate electrode (16).
